# EUROPEAN PATENT APPLICATION

(11) **EP 4 642 158 A2**
(43) Date of publication of application: **29.10.2025**
(21) Application number: 25163202.2
(22) Date of filing: 12.03.2025
(51) Int. Cl.: H05B 6/06, H05B 6/10, H05B 6/44, H01L 21/67

(54) **SUBSTRATE PROCESSING APPARATUS, METHOD OF PROCESSING SUBSTRATE, INDUCTION HEATING APPARATUS, AND INDUCTION HEATING METHOD**

(30) Priority: 25.04.2024 JP 2024071220; 27.12.2024 JP 2024231663
(71) Applicant: Kokusai Electric Corporation, Tokyo 101-0045 (JP)
(72) Inventor: OHISHI, Mamoru, 939-2393, Toyama-shi, Toyama (JP); HARA, Naoki, Toyama-shi, Toyama, 939-2393 (JP); HARA, Daisuke, Toyama-shi, Toyama, 939-2393 (JP); NOBATA, Ryoji, Aichi-ken, 448-8533 (JP); HASHIMOTO, Susumu, Aichi-ken, 448-8533 (JP)
(74) Representative: Bardehle Pagenberg Partnerschaft mbB Patentanwälte Rechtsanwälte

(57) **Abstract**

There is provided a technique that includes (a) a process tube (7) in which a substrate (4) is accommodated and heat-treated; (b) a plurality of coils (12U, 12M, 12L) that are disposed along a longitudinal direction of the process tube (7) and supplied with radio-frequency power from a power source (13U, 13M, 13L); and (c) a controller (210) configured to be capable of setting a phase difference between two adjacent coils, among the plurality of coils (12U, 12M, 12L), to a predetermined value, wherein in (c) the predetermined value is changeable and is set so as to make a temperature discrepancy occurring in a vicinity of a boundary between the two adjacent coils smaller than a temperature discrepancy when the phase difference is set to zero.

## Description

### CROSS-REFERENCE TO RELATED APPLICATIONS

This application is based upon and claims the benefit of priority from Japanese Patent Application No. 2024-071220, filed on April 25, 2024, and Japanese Patent Application No. 2024-231663, filed on December 27, 2024, the entire contents of which are incorporated herein by reference.

### TECHNICAL FIELD

The present disclosure relates to a substrate processing apparatus, a method of processing a substrate, an induction heating apparatus, and an induction heating method.

### BACKGROUND

In a method of manufacturing a semiconductor device, a vertical substrate processing apparatus may be used as an apparatus for forming or annealing an oxide film or the like on a substrate (hereinafter referred to as a wafer). When performing such process on the wafer, while supplying a process gas into a process chamber, an interior of the process chamber is inductively heated to a predetermined temperature by using a magnetic coil. In order to maintain the interior of the process chamber at the predetermined temperature, a temperature sensor for detecting the temperature, such as a thermocouple, may be provided in the process chamber.

When the process chamber is divided into a plurality of induction heating zones for heating, temperature discrepancies may occur at zone boundaries.

### SUMMARY

Some embodiments of the present disclosure provide a technique capable of reducing temperature discrepancies at zone boundaries of induction heating.

According to embodiments of the present disclosure, there is provided a technique that includes (a) a process tube in which a substrate is accommodated and heat-treated; (b) a plurality of coils that are disposed along a longitudinal direction of the process tube and supplied with radio-frequency power from a power source; and (c) a controller configured to be capable of setting a phase difference between two adjacent coils, among the plurality of coils, to a predetermined value, wherein in (c) the predetermined value is changeable and is set so as to make a temperature discrepancy occurring in a vicinity of a boundary between the two adjacent coils smaller than a temperature discrepancy when the phase difference is set to zero.

### BRIEF DESCRIPTION OF DRAWINGS

The accompanying drawings, which are incorporated in and constitute a part of the specification, illustrate embodiments of the present disclosure.
FIG. 1 is a longitudinal cross-sectional view of a process furnace according to embodiments of the present disclosure.
FIG. 2 is a schematic configuration diagram of a controller of a substrate processing apparatus according to the embodiments of the present disclosure.
FIG. 3 is a block diagram of a power supply circuit according to the embodiments of the present disclosure.
FIG. 4 is a diagram for explaining a method of measuring a temperature profile according to the embodiments of the present disclosure.
FIG. 5 is a diagram for explaining setting a phase difference of a drive voltage between coils according to the embodiments of the present disclosure.
FIG. 6 is a diagram showing an improvement in temperature ripple by a phase difference according to the embodiments of the present disclosure.
FIG. 7 is a flow diagram of substrate processing according to the embodiments of the present disclosure.
FIG. 8 is a control flow diagram of a temperature rising process according to the embodiments of the present disclosure.
FIG. 9 is a diagram showing a temperature control result when there is power reduction according to the embodiments of the present disclosure.
FIG. 10 is a diagram showing a temperature control result when there is no power reduction according to a comparative example.
FIG. 11 is a block diagram of a power supply according to a modification of the present disclosure.
FIG. 12 is a diagram for explaining synchronization of inverter circuits in the power supply according to the modification of the present disclosure.
FIG. 13 is a flow diagram for explaining a method of setting a reference phase of the power supply according to the modification of the present disclosure.
FIG. 14 is a perspective view of an induction heating apparatus juxtaposed to a substrate processing apparatus according to the modification of the present disclosure.
FIG. 15 is a diagram for explaining a rack for the induction heating apparatus according to the modification of the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

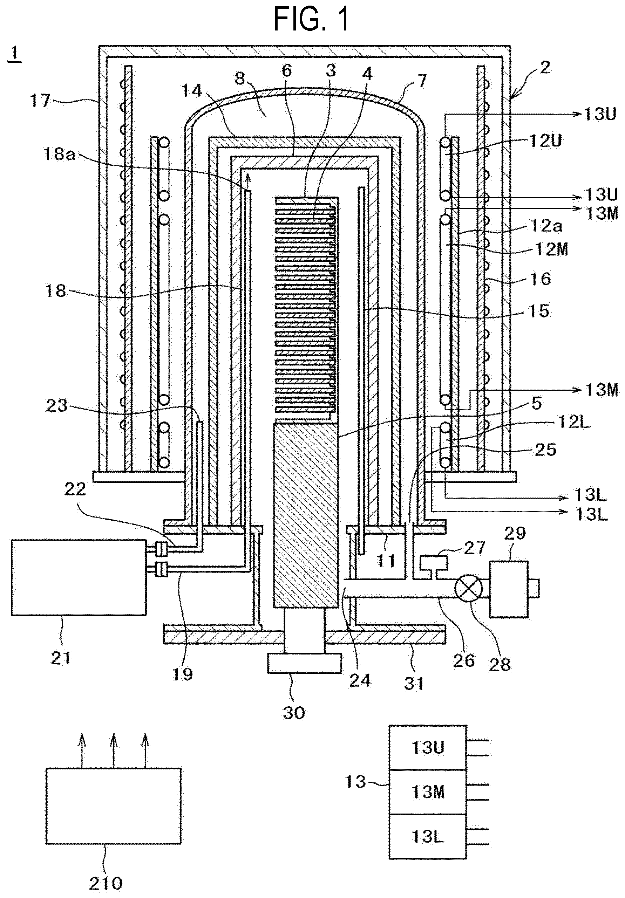

Embodiments of the present disclosure are now described mainly with reference to FIGS. 1 to 8. The drawings used in the following description are schematic, and the dimensional relationship, proportions, and the like of various elements shown in the drawings do not always match the actual ones. Further, the dimensional relationship, proportions, and the like of various elements among plural figures do not always match one another. Further, in the drawings, substantially the same elements are denoted by the same reference numerals, and explanation thereof may not be repeated. Furthermore, unless otherwise specified in the specification, each element is not limited to one, and may be present in plural.

### (1) Configuration of Substrate Processing Apparatus

A substrate processing apparatus 1 is configured as a batch-type vertical annealing apparatus that performs an annealing process on a plurality of silicon carbide (SiC) substrates aligned in a vertical direction. By configuring it as a batch-type processing apparatus, it becomes possible to process many substrates at a time, thereby improving productivity.

The substrate processing apparatus 1 includes a process furnace 2, and a boat 3 as a substrate holder is configured to be insertable/detachable into/from the process furnace 2. The boat 3 is made of a heat resistant material such as carbon graphite or SiC. The boat 3 is configured to hold a plurality of wafers 4, which are substrates to be processed and are made of SiC or the like, stacked vertically in a horizontal posture with their centers aligned with one another.

A heat insulator 5, which is made of a heat resistant material such as SiC, is disposed at a bottom of the boat 3. The heat insulator 5 is configured to support the boat 3 from below to make it difficult for heat from a heating element 6, which is described later, to be transmitted to a lower side of the process furnace 2. The boat 3 charged with a plurality of wafers 4 is loaded into the process furnace 2, whereby heat treatment is performed.

As shown in FIG. 1, the process furnace 2 includes a reaction tube 7 as a process tube which is made of a heat resistant material such as quartz or SiC and is formed in a cylindrical shape with its upper end closed and its lower end opened. A reaction chamber 8 as a process chamber is formed in a hollow cylindrical portion of the reaction tube 7. The reaction chamber 8 is configured to accommodate the above-described boat 3 which holds the wafers 4 made of SiC or the like as substrates to be processed.

A manifold 11 is disposed below the reaction tube 7 to be concentric with the reaction tube 7. The manifold 11 is made of, for example, metal and is formed in a cylindrical shape with both upper and lower ends opened. The manifold 11 is provided to support the reaction tube 7 from below. An O-ring (not shown) as a seal is provided between the manifold 11 and the reaction tube 7. The reaction tube 7 and the manifold 11 form a reaction container.

The process furnace 2 includes a heating element 6 as a heated body (susceptor) heated by induction heating, and an induction coil 12 (12U, 12M, and 12L) as an induction heater, i.e., a magnetic field generator. The induction coil 12 is disposed along a longitudinal direction of the reaction tube 7 and is configured as a plurality of induction coils including a first coil 12U as an upper coil, a second coil 12M as an intermediate coil, and a third coil 12L as a lower coil. The second coil 12M is provided outside the reaction tube 7 so as to surround an accommodation region of the wafers 4. The second coil 12M is provided so as to surround a central portion of the accommodation region of the wafers 4, excluding upper and lower sides of the accommodation region of the wafers 4. The first coil 12U is provided above the second coil 12M and outside the reaction tube 7. The third coil 12L is provided below the second coil 12M and outside the reaction tube 7 so as to surround an upper portion of the heat insulator 5. The reaction chamber 8 or the heating element 6 may be virtually divided into three zones, i.e., a first zone ZN1, a second zone ZN2, and a third zone ZN3, which are continuous in the longitudinal direction, corresponding to these three induction coils. The second zone ZN2 corresponds to the accommodation region of the wafers 4 to be processed and is a region in which uniform heating is needed.

The heating element 6 may be rephrased as a susceptor. The heating element 6 is formed in a cylindrical shape from a conductive heat resistant material such as carbon and is provided so as to surround the boat 3 accommodated in the reaction chamber 8, i.e., to surround the accommodation region of the wafers 4. The heating element 6 is formed in a cylindrical shape with both upper and lower ends opened, or a cylindrical shape with its upper end closed and its lower end opened. The induction coil 12 is supported by a coil support 12a made of an insulating heat resistant material and is provided to surround an outer periphery of the reaction tube 7. In other words, the heating element 6 is configured in a cylindrical shape that is disposed to be approximately concentric with the process tube 7.

When a pitch of the coil is defined as a distance between two adjacent turns of the coil, a pitch P12U of a coil winding of the first coil 12U is narrower than a pitch P12M of a coil winding of the second coil 12M (P 12U<P 12M). Further, a pitch P12L of a coil winding of the third coil 12L is narrower than the pitch P12M of the coil winding of the second coil 12M (P12L<P12M). Further, the plurality of coils (12U, 12M, and 12L) are wound around the reaction tube 7 for each of the plurality of zones obtained by dividing the reaction tube 7 in the longitudinal direction, and a distance between two adjacent coils (between the first coil 12U and the second coil 12M or between the second coil 12M and the third coil 12L) is wider than the pitch of each of the two coils. That is, the first coil 12U and the second coil 12M are spaced apart from each other by a larger distance than the pitch P12U of the first coil 12U or the pitch P12M of the second coil 12M. Similarly, the second coil 12M and the third coil 12L are spaced apart from each other by a larger distance than the pitch P12M of the second coil 12M or the pitch P12L of the third coil 12L. The plurality of induction coils (12U, 12M, and 12L) include the first coil 12U, the second coil 12M, and the third coil 12L arranged in order in the longitudinal direction of the process tube 7. The second coil 12M is longer than the pitches (P12U and P12L) of the windings of the other coils (12U and 12L) and is formed with a wider pitch P12M of the winding of the coil. The accommodation region of the wafers 4 as a region of the process tube 7 to be uniformly heated (also called a uniformly heated region) is set to extend beyond both ends of the second coil 12M. Further, at least one of the plurality of induction coils (12U, 12M, and 12L) is configured such that its length in the longitudinal direction of the process tube 7 is greater than its diameter. With this configuration, a heating section needed to obtain a predetermined uniform heating length may be shortened, which may lead to reduction of an apparatus cost, an operating cost, and power consumption of the substrate processing apparatus 1.

The induction coil 12 (12U, 12M, and 12L) is supplied with radio-frequency power, for example, AC power of 10 to 450 kHz and 10 to 200 kW, from an AC power source 13 (13U, 13M, and 13L) serving as a power supply. The AC power source 13 (13U, 13M, and 13L) includes a first AC power source 13U that supplies AC power to the first coil 12U, a second AC power source 13M that supplies AC power to the second coil 12M, and a third AC power source 13L that supplies AC power to the third coil 12L. The AC power source 13 is configured to be capable of maintaining a phase difference at a set predetermined value while controlling the power supplied to the plurality of induction coils (12U, 12M, and 12L) to a specified value. The AC power source 13 is configured to be capable of exciting two adjacent coils (the first coil 12U and the second coil 12M, or the second coil 12M and the third coil 12L), among the plurality of induction coils (12U, 12M, and 12L), with a waveform of an arbitrary phase difference within a predetermined range before and after the phase difference of 180 degrees, which is an opposite phase. For example, with a phase of the AC power supplied to the second coil 12M by the second AC power source 13M as a reference, the first AC power source 13U may set a phase of the AC power supplied to the first coil 12U to be shifted to a positive side with a phase difference within a predetermined range, and the third AC power source 13L may set a phase of the AC power supplied to the third coil 12L to be shifted to a negative side with a phase difference within a predetermined range.

The heating element 6 is located to be closer to the substrate 4 than the plurality of induction coils (12U, 12M, and 12L) and is inductively heated by the plurality of induction coils (12U, 12M, and 12L). The heating element 6 is disposed over a longer range in the longitudinal direction of the process tube 7 than any of the plurality of induction coils (12U, 12M, and 12L).

An induced current flows through the heating element 6 due to an alternating magnetic field generated by flowing an alternating current through the induction coil 12, whereby the heating element 6 generates heat due to Joule heat. As the heating element 6 generates heat, the wafers 4 held in the boat 3 are heated to a predetermined processing temperature, for example, 1,500 degrees C to 2,000 degrees C, by radiant heat emitted from the heating element 6. At this time, in order to prevent thermal damage, it is preferable to maintain a temperature of constituent members below the process furnace 2 at a temperature of, for example, 200 degrees C or lower. The denotation of a numerical range such as "1,500 degrees C to 2,000 degrees C" means that the lower limit and the upper limit are included in the range. Thus, for example, "1,500 degrees C to 2,000 degrees C" means "1,500 degrees C or higher and 2,000 degrees C or lower". In the present disclosure, a processing temperature means the temperature of the wafer 4 or an internal temperature of the process chamber 8, and a processing pressure means an internal pressure of the process chamber 8. Further, processing time means time the processing continues. These are the same in the following descriptions.

Of the coils (the first coil 12U, the second coil 12M, and the third coil 12L) in the three zones (the first zone ZN1, the second zone ZN2, and the third zone ZN3), the coils on both sides (the first coil 12U and the third coil 12L) simulate a case where the central coil (the second coil 12M) is formed with an infinite length, and are configured to heat more strongly than the central coil (the second coil 12M). In other words, the coils on both sides (the first coil 12U and the third coil 12L) are configured so that a density of magnetic flux per unit area of the heating element 6 is high. That is, input power per unit length in the longitudinal direction (tube axis direction) of the process tube 7 is large for the coils on both sides (the first coil 12U and the third coil 12L).

At this time, consider a case where the pitches of the coils (the first coil 12U, the second coil 12M, and the third coil 12L) in the three zones are the same and gaps among the coils (the first coil 12U, the second coil 12M, and the third coil 12L) are also the same as the pitch. In this case, a strong magnetic flux of the coils on both sides (the first coil 12U and the third coil 12L) penetrates deep into the central zone (the second zone ZN2), which makes it not possible to control to just compensate for a temperature drop in a vicinity of both ends of the central zone (the second zone ZN2), thereby making it difficult to achieve uniform heating of the entire central zone (the second zone ZN2).

Therefore, in the present disclosure, it is preferable to space the gap between two adjacent coils (the first coil 12U and the second coil 12M, or the second coil 12M and the third coil 12L) to be wider than the pitch of each of the two coils (the first coil 12U and the second coil 12M, or the second coil 12M and the third coil 12L). In particular, it is preferable to make the length of the coil (the second coil 12M) in the central zone (the second zone ZN2) shorter than a uniform heating section (the accommodation region of the wafers 4) and to place the gap (between the first coil 12U and the second coil 12M, or the second coil 12M and the third coil 12L) in a vicinity of both ends of the uniform heating section (accommodation region of the wafers 4).

A heat insulator 14 is provided between the reaction tube 7 and the heating element 6. The heat insulator 14 is formed in a cylindrical shape with its upper end closed and its lower end opened.

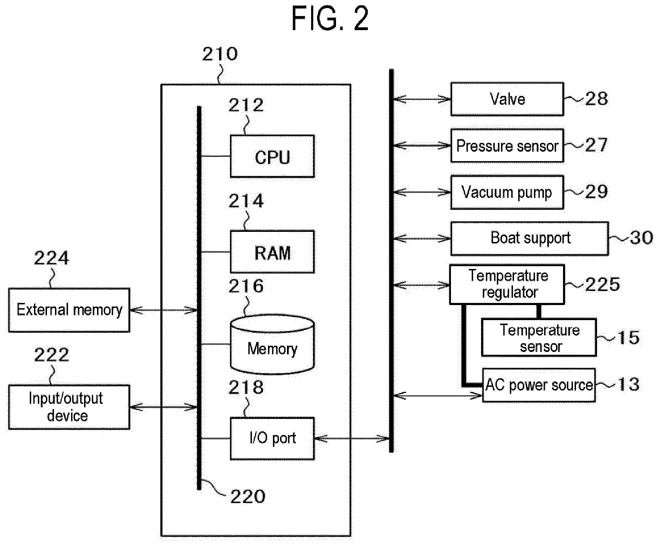

Further, a temperature sensor 15 for detecting the processing temperature is provided between the heating element 6 and the boat 3 holding the wafers 4. The temperature sensor 15 measures temperatures at three points corresponding to upper end, middle, and lower end of the arrangement region of the wafers 4 of the boat 3 and, as shown in FIG. 2, is electrically connected to a temperature regulator 225 as a temperature controller. The temperature sensor 15 may be composed of a plurality of thermocouples accommodated in a protective tube that penetrates the manifold 11 and is installed vertically. Specifically, three temperature measurement assemblies, each including two thermocouples, one for use and the other for spare, accommodated in the protective tube, are installed corresponding to the above-mentioned three points. At least one selected from the group of the temperature measurement assemblies extends to a vicinity of an upper end of the boat 3. A radiation thermometer may be used as the temperature sensor 15.

The temperature regulator 225 regulates a phase of the power or voltage supplied from the AC power source 13 to the induction coil 12 based on temperature information detected by the temperature sensor 15, thereby controlling the processing temperature of the wafers 4 to a desired temperature. A heater according to the embodiments mainly includes the heating element 6, the induction coil 12, the AC power source 13, and the temperature sensor 15.

In addition, an outer heat insulating wall 16 including, for example, a water-cooling structure, which suppresses transfer of heat from an interior of the reaction chamber 8 to an outside, is provided outside the induction coil 12 so as to surround the reaction chamber 8. Further, a magnetic shield 17, which prevents a magnetic field generated by the induction coil 12 from leaking to an outside, is provided outside the outer heat insulating wall 16.

A first gas nozzle 18 including a first gas supply port 18a at its upper end, etc. is disposed at the process furnace 2. The first gas nozzle 18 is disposed vertically between the accommodation region of the wafers 4 and the heating element 6 at an inner side of the heating element 6. The first gas nozzle 18 is connected to a first gas supply pipe 19 that is provided to penetrate the manifold 11. A gas supply unit 21 is connected to an upstream end of the first gas supply pipe 19.

A second gas supply pipe 22 is disposed vertically between the heat insulator 14 and the reaction tube 7 at an outer side of the heating element 6. A second gas supply port 23 is provided at a downstream end of the second gas supply pipe 22. The second gas supply pipe 22 is provided to penetrate the manifold 11. The gas supply unit 21 is connected to an upstream end of the second gas supply pipe 22.

A first exhaust port 24 is formed on a side from the heat insulator 5, i.e., below the accommodation region of the wafers 4 and at a sidewall of the manifold 11 that faces the first gas supply port 18a. In addition, a second exhaust port 25 is formed between the heat insulator 14 and the reaction tube 7 and at a constituent wall of the manifold 11 on which the reaction tube 7 is mounted. Upstream ends of a branched exhaust pipe 26 are connected to the first exhaust port 24 and the second exhaust port 25, respectively. The exhaust pipe 26 is provided with a pressure sensor 27 as a pressure detector, an APC (Auto Pressure Controller) valve 28 as a pressure regulator, and a vacuum pump 29 as a vacuum exhauster, in that order from an upstream. The pressure sensor 27, the APC valve 28, and the vacuum pump 29 are electrically connected to a pressure controller (not shown). The pressure controller feedback-controls an opening degree of the APC valve 28 based on pressure information measured by the pressure sensor 27, thereby controlling the internal pressure of the reaction chamber 8 to a predetermined pressure.

Further, by providing the second exhaust port 25 as described above, a purge gas, which is an inert gas such as nitrogen supplied from the second gas supply port 23 into the reaction chamber 8, purges a space between the reaction tube 7 and the heat insulator 14 and is exhausted through the second exhaust port 25.

Furthermore, the boat 3 is capable of being loaded into the reaction chamber 8, i.e., boat loading, and being unloaded from the reaction chamber 8, i.e., boat unloading, by a lift(not shown). By loading the boat 3 into the reaction chamber 8, an opening, i.e., a furnace opening, of the process furnace 2, is configured to be air-tightly closed by a seal cap 31 via a seal such as an O-ring. Furthermore, the heat insulator 5 may be rotatably supported by a boat support 30 provided at the seal cap 31.

A controller 210 controls various parts (26, 27, 28, 29, 30, and 225) of the substrate processing apparatus 1 and include a central processing unit (CPU) 212, a main memory 216, and an external memory 224 (auxiliary memory), as described in FIG. 2. The external memory 224 stores recipe information that defines a series of operations for performing an annealing process and the like in the substrate processing apparatus 1, and a program executed by the CPU 212 to actually control the substrate processing apparatus 1 based on the recipe information. The external memory 224 may include a recording medium such as an optical disc.

### (Controller)

FIG. 2 is a schematic configuration diagram of a controller of the substrate processing apparatus according to the embodiments of the present disclosure. As shown in FIG. 2, the controller 210, which is a control part (control device or control means), is configured as a computer including a CPU (Central Processing Unit) 212, a RAM (Random Access Memory) 214, a memory (main memory) 216, and an I/O port 218. The RAM 214, the main memory 216, and the I/O port 218 are configured to be capable of exchanging data with the CPU 212 via an internal bus 220. An input/output device 222 configured as, for example, a touch panel and the like is connected to the controller 210.

The main memory 216 is configured with, for example, a flash memory, a HDD (Hard Disk Drive), etc. A control program for controlling the operations of the substrate processing apparatus, a process recipe in which procedures and conditions of an annealing (modification) process and the like are written, etc. are readably stored in the main memory 216. The process recipe functions as a program that executes each sequence in a substrate processing process, which is described later, in the controller 210 to obtain a predetermined result. Hereinafter, the process recipe and the control program may be generally and simply referred to as a "program." Furthermore, the process recipe may be simply referred to as a "recipe." When the term "program" is used herein, it may indicate a case of including the recipe, a case of including the control program, or a case of including both the recipe and the control program. The RAM 214 is configured as a memory area (work area) in which programs or data read by the CPU 212 are temporarily stored.

The I/O port 218 is connected to the above-described valve 28, pressure sensor 27, vacuum pump 29, boat support 30, temperature regulator 225, and the like.

The CPU 212 is configured to be capable of reading and executing the control program from the main memory 216 and reading the recipe from the main memory 216 in response to an input of an operation command from the input/output device 222. The CPU 212 is configured to be capable of controlling the following control targets in accordance with the contents of the read recipe. The control targets are, for example, the pressure regulating operation performed by the APC valve 28 based on the pressure sensor 27, the actuating and stopping operation of the vacuum pump 29, the temperature regulating operation performed by the temperature regulator 225 of the AC power source 13 based on the temperature sensor 15, the rotating and rotation speed adjusting operations or lifting operation of the boat 3 by the boat support 30, and so on.

The controller 210 may be configured by installing, on the computer, the aforementioned program stored in the external memory 224. The external memory 224 is, for example, a magnetic disk such as a hard disk, an optical disc such as a CD, a magneto-optical disk such as a MO, or a semiconductor memory such as a USB memory or a SSD. The main memory 216 and the external memory 224 are configured as non-transitory computer-readable recording media. Hereinafter, the main memory 216 and the external memory 224 may be generally referred to simply as a "recording medium." When the term "recording medium" is used herein, it may indicate a case of including the main memory 216, a case of including the external memory 224, or a case of including both the main memory 216 and the external memory 224. Furthermore, the program may be provided to the computer by using communication means such as the Internet or a dedicated line, instead of using the external memory 224.

The controller 210 sets a target temperature of each of the zones (ZN1, ZN2, and ZN3) in the temperature regulator 225, and the temperature regulator 225 outputs power setting values 122U, 122M, and 122L, which are manipulated variables, to each of the AC power sources 13 (13U, 13M, and 13L) by using PID control (proportional, integral, and differential control), to approach a temperature of the thermocouple to the target temperature. That is, the temperature regulator 225 outputs a plurality of manipulated variables (the power setting values 122U, 122M, and 122L) representing the power to be supplied to the plurality of coils (the first coil 12U, the second coil 12M, and the third coil 12L), such that a plurality of temperature values corresponding to the plurality of zones (ZN1, ZN2, and ZN3) obtained from a plurality of temperature sensors 15 approach the target values of the corresponding target temperatures.

On the other hand, the controller 210 directly sets semifixed phase shift amounts (constant phase amounts) 121U, 121M, and 121L for the AC power sources 13 (13U, 13M, and 13L), respectively, without going through the temperature regulator 225. In other words, the controller 210 is configured to be capable of setting a phase difference between two adjacent coils (a phase difference between the first coil 12U and the second coil 12M, and a phase difference between the second coil 12M and the third coil 12L) among the plurality of coils (the first coil 12U, the second coil 12M, and the third coil 12L) to a predetermined value by using the semifixed phase shift amounts 121U, 121M, and 121L. This predetermined value is changeable without hardware modification and is set so as to make a temperature discrepancy occurring in a gap between the two adjacent coils (between the first coil 12U and the second coil 12M and between the second coil 12M and the third coil 12L) and its vicinity smaller than that when the phase difference is set to zero. Herein, the vicinity usually means a region narrower than each of the plurality of heating zones. The vicinity may be defined as a end portion of a coil where the magnetic field generated by the coil attenuates to (1-1/e) or less of the magnetic field at the center on the central axis of the coil. In such a region, although the temperature at the three temperature measurement points is controlled to match the target value, further away from the three temperature measurement points, a temperature error may become larger. The gap between two adjacent coils and the vicinity of the gap are hereinafter called as the vicinity of a boundary between the two adjacent coils.

Note that the temperature regulator 225 may be configured as a part of the controller 210, or may be provided separately from the controller 210, as shown in FIG. 2.

### (Power Supply)

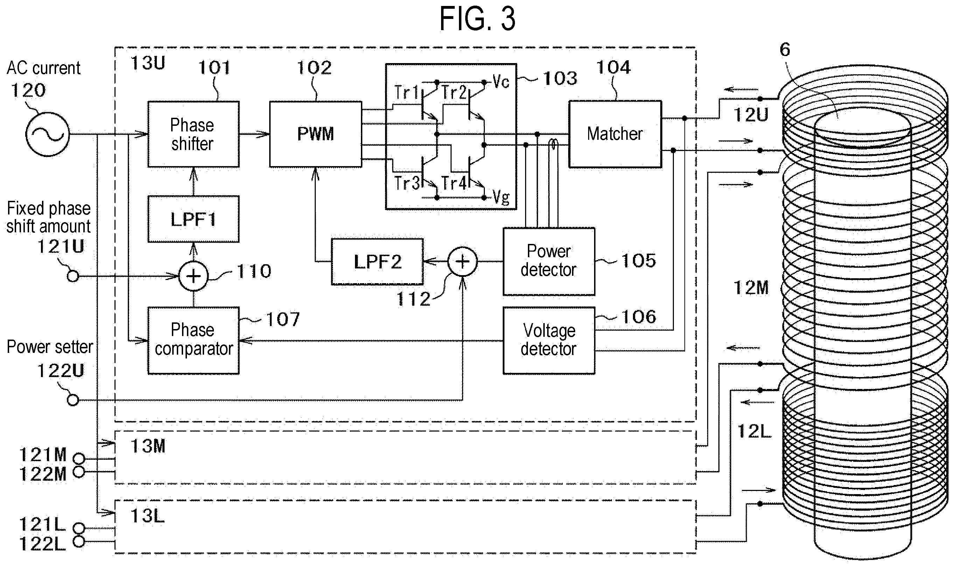

FIG. 3 is a block diagram of a power supply according to the embodiments of the present disclosure. In FIG. 3, a circuit configuration of the first AC power source 13U that supplies the AC power to the first coil 12U, among the AC power sources 13 (13U, 13M, and 13L) as the power supplies, is shown as a representative example. Circuit configurations of the second AC power source 13M that supplies the AC power to the second coil 12M and the third AC power source 13L that supplies the AC power to the third coil 12L are the same as those of the first AC power source 13U, so to simplify the figure, the circuit configuration of the first AC power source 13U alone is illustrated.

The first AC power source 13U includes a phase shifter 101, a PWM (pulse width modulation) circuit 102, a bridge circuit 103, a matcher 104, low-pass filters LPF1 and LPF2, a power detector 105, a voltage detector 106, and a phase comparator (phase shift comparator) 107.

The phase shifter 101 receives a signal from an oscillator 120 and is configured to change a phase or a delay of a signal from the oscillator 120 so that the phase of the power supplied to the first coil 12U is regulated by the constant phase amount 121U. An output of the phase shifter 101 is supplied to an input of the PWM circuit 102.

The PWM circuit 102 generates first to third drive signals to be supplied to the bridge circuit 103, based on an output voltage of the phase shifter 101. The bridge circuit 103 includes transistors Tr1 and Tr3 including respective collector-emitter paths connected in series between a positive potential Vc and a negative potential Vg, and transistors Tr2 and Tr4 including respective collector-emitter paths connected in series between the positive potential Vc and the negative potential Vg.

The PWM circuit 102 is configured to be capable of generating the first drive signal that turns on the transistors Tr1 and Tr4 of the bridge circuit 103, the second drive signal that turns on the transistors Tr2 and Tr3 of the bridge circuit 103, or the third drive signal that turns off the entire transistors Tr1 to Tr4 of the bridge circuit 103.

An output signal of the bridge circuit 103 is configured to be supplied to the first coil 12U via the matcher 104 so as to control the driving of the first coil 12U.

The output signal of the bridge circuit 103 is configured such that the power is detected by the power detector 105, the detected output of the power detector 105 is subtracted from the power setting value 122U by a subtractor 112, and a signal obtained by the subtraction is input to the PWM circuit 102 via the low-pass filter LPF2. In this way, the PWM circuit 102 is configured to drive the first coil 12U with a desired power.

Further, an output wiring of the matcher 104 to which the first coil 12U is connected is connected to the voltage detector 106, and an output voltage of the matcher 104 is detected by the voltage detector 106. The phase comparator 107 receives an output of the voltage detector 106 and the signal from the oscillator 120 and outputs a voltage or a numerical value according to a phase difference between them. The subtractor 110 subtracts a phase comparison result of the phase comparator 107 from the constant phase amount 121U. A subtraction result of the subtractor 110 is supplied to the phase shifter 101 via the low-pass filter LPF1. The phase shifter 101 is configured to, for example, shift the phase linearly according to a voltage or a value output by the low-pass filter LPF1. This allows the phase of the voltage driving the first coil 12U to be controlled so as to be locked in a desired state.

The second AC power source 13M and the third AC power source 13L are also configured so that the phase and power of the voltage driving the second coil 12M and the third coil 12L may be controlled as desired by the constant phase amounts 121M and 121L and the power setting values 122M and 122L.

The AC power source 13 (13U, 13M, and 13L) is configured to be capable of electrically changing the predetermined values as the constant phase amounts 121U, 121M, and 121L by changing the phase difference of the voltage output corresponding to each of the plurality of coils (12U, 12M, and 12L).

As shown in FIG. 3, the first coil 12U, the second coil 12M, and the third coil 12L are wound in the same way. In this example, when viewed from above, each of the coils (12U, 12M, and 12L) is wound right-handed (clockwise). In the second coil 12M, a current flowing through the second coil 12M is input from an upper side of the second coil 12M and output from a lower side of the second coil 12M. A current flowing through the first coil 12U is input from a lower side of the first coil 12U and output from an upper side of the first coil 12U. A current flowing through the third coil 12L is input from a lower side of the third coil 12L and output from an upper side of the third coil 12L. Current directions of the first coil 12U and the third coil 12L is in an opposite phase to a current direction of the second coil 12M. Since the coil pitches of the coils (12U, 12M, and 12L) and the dimensions among the coils (12U, 12M, and 12L) are described above, duplicate explanations thereof are not repeated.

Herein, when there is mutual induction between the coils (between the first coil 12U and the second coil 12M or between the second coil 12M and the third coil 12L), power controls interfere with each other and become unstable. In the case of PWM drive control in which power control is performed by varying on-periods of the transistors Tr1 to Tr4 of the bridge circuit 103, changing the power changes a voltage waveform, shifting a voltage phase and changing a degree of influence of mutual induction, thereby making the control unstable.

In contrast, in the present disclosure, voltage waveforms at both ends of the first coil 12U, the second coil 12M, and the third coil 12L are acquired by the voltage detector 106, and the phase differences of the drive voltages between the first coil 12U, the second coil 12M, and the third coil 12L are fixed as desired using the constant phase amounts 121U, 121M, and 121L, thereby solving the problem of the above control becoming unstable.

Note that, in the above, the semifixed phase shift amount is described as voltage phase control, but is not limited thereto. The semifixed phase shift amount may be current phase control or power phase control, etc. without being limited to the voltage phase control.

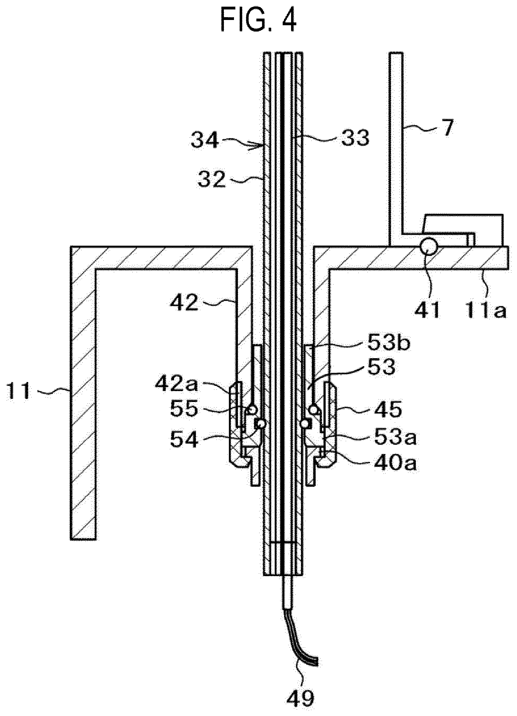

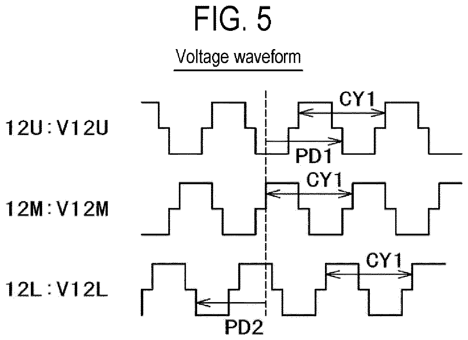

Next, a method of setting a phase difference according to the embodiments of the present disclosure is described with reference to FIGS. 4 and 5. In the present disclosure, for example, the following steps 1), 2), and 3) are repeatedly performed.

Step 1) While maintaining the interior of the reaction chamber 8 at approximately atmospheric pressure or a reduced pressure non-oxidizing atmosphere, the temperature regulator 225 heats a disposition region of the wafers 4 to a predetermined temperature. At this time, the constant phase amounts 121U, 121M, and 121L are set using the temperature regulator 225 under the control of the controller 210. Then, a sheathed thermocouple 33, which is described later, is inserted into the reaction tube 7, and a temperature profile of the entire disposition region of the wafers 4, including the three temperature measurement points at an upper end, middle, and lower end of the disposition region of the wafers 4 of the boat 3, is measured while moving the temperature measurement points in the tube axial direction. A range of the temperature profile may include a heat insulating region in which the heat insulator 5 is placed.

Step 2) In the temperature profile, it is evaluated whether or not a temperature ripple is within a predetermined value, and when the temperature ripple is within the predetermined value, the procedure ends.

Step 3) The controller 210 changes at least one selected from the group of the constant phase amounts 121U, 121M, and 121L given to the temperature regulator 225. The change may be performed in a cut-and-try manner, or may be determined using, for example, a local search method such as a hill-climbing method, or a genetic algorithm.

The above-described steps 1) to 3) are repeated until temperature deviations at the upper end, middle, and lower end of the disposition region of the wafers 4 of the boat 3 are within a predetermined value. This makes it possible to reduce the temperature discrepancy at the zone boundaries of induction heating using the first coil 12U, the second coil 12M, and the third coil 12L by controlling the phase difference of the voltage that drives the induction coils 12U, 12M, and 12L. In other words, the deviations (spatial fluctuation) from the target values of the temperatures in the vicinity of the zone boundaries may be reduced by directly controlling the phase difference of the voltage, thereby improving heat uniformity.

FIG. 4 shows an installation of a temperature measurement assembly 34 used in step 1. As shown in FIG. 4, the manifold 11 includes an annular flange 11a, which expands outward in a circumferential direction, at its upper end, and the reaction tube 7 is mounted on the flange 11a. An O-ring 41 is provided between the reaction tube 7 and the flange 11a, and the O-ring 41 ensures airtightness between the reaction tube 7 and the flange 11a. The O-ring 41 and the flange 11a may be considered as a part of a lid that closes an opening of the reaction tube (process tube) 7.

Further, a TC port 42 for temperature profile measurement is formed at the flange 11a. The TC port 42 is formed in a cylindrical shape that extends downward in parallel with the axis of the reaction tube 7. An inner diameter of a lower end of the TC port 42 is enlarged, and a threaded portion 42a is formed on an outer periphery thereof. The TC port 42 may include a structure similar to the port to which the temperature sensor 15 is attached. A plug is inserted into the TC port 42 to seal it airtight except when the temperature profile is being measured.

The temperature measurement assembly 34 for temperature profile measurement includes a sheathed thermocouple 33 and a protective tube 32 that protects the sheathed thermocouple 33. The sheathed thermocouple 33 includes a sheath tube and a thermocouple (TC) as a temperature measuring part which is sealed in the sheath tube. The sheathed thermocouple 33 is bonded to the protective tube 32 in a vicinity of a lower end of the protective tube 32.

A sleeve 53 is formed in a cylindrical shape and is fitted into a gap at an inner side of the TC port 42. The sleeve 53 includes a large diameter portion 53a and a small diameter portion 53b that is smaller in diameter than the large diameter portion 53a. An outer diameter of the large diameter portion 53a is larger than an inner diameter of the TC port 42 above the lower end. An outer diameter of the small diameter portion 53b is slightly smaller than the inner diameter of the TC port 42 above the lower end. The sleeve 53 is inserted from a side of the lower end of the TC port 42 with the small diameter portion 53b facing up. Furthermore, a groove is provided around an entire inner wall of the large diameter portion 53a, and an O-ring 54 is disposed therein as a first airtight member. An O-ring 55 is disposed in an outer periphery of a lower end of the small diameter portion 53b as a second airtight member.

A cap nut 45 is screwed onto the threaded portion 42a, compressing the O-ring 55 to seal between the TC port 42 and the sleeve 53.

When the protective tube 32 is inserted into the sleeve 53, the O-ring 54 is pressed by an outer wall of the protective tube 32, and a certain degree of airtightness is obtained between the sleeve 53 and the protective tube 32. At this time, it is preferable that the O-ring 54 possesses a frictional force sufficient to prevent the temperature measurement assembly 34 from falling.

When using the temperature measurement assembly 34 to measure the temperature profile of the process furnace 2, the cap nut 45 is tightened to fix the sleeve 53 while the protective tube 32 is inserted into the sleeve 53. Then, while sliding the protective tube 32 against the O-ring 54, the temperature measurement assembly 34 is inserted and removed to change a position of the temperature measurement point by a predetermined amount, and a temperature detected by the thermocouple is recorded. By repeating this, a temperature distribution in the tube axis direction may be measured. Note that the protective tube 32 and the sleeve 53 may be formed integrally and the O-ring 54 may be eliminated. In this case, the protective tube 32 is fixed airtight to the TC port 42 by tightening the cap nut 45. Then, the sheathed thermocouple 33 is inserted/removed into/from the protective tube 32 to change the position of the temperature measurement point. In other words, the sheathed thermocouple 33 is configured to be freely movable without being fixed to the protective tube 32. With this method, it is possible to measure the interior of the process chamber 8 in the same reduced pressure state as during actual processing.

FIG. 5 is a diagram for explaining the constant phase amount set in step 3). FIG. 5 shows an example of drive voltages V12U, V12M, and V12L of the first coil 12U, second coil 12M, and third coil 12L. Herein, the drive voltages V12U, V12M, and V12L possess a frequency of, for example, 10 kHz and a same period CY1. On the other hand, when a phase of the drive voltage V12M of the second coil 12M is used as a reference, a phase difference of the drive voltage V12U is set as a first phase difference PD1, and a phase difference of the drive voltage V12L is set as a second phase difference PD2. The first phase difference PD1 and the second phase difference PD2 may be controlled by regulating the constant phase amounts 121U and 121L with the constant phase amount 121M as a reference. Herein, since the phase difference is defined based on a direction of a magnetic flux linkage of the coils, the voltage waveforms of the first coil 12U and the third coil 12L, which are driven in opposite phases, are inverted again before being measured.

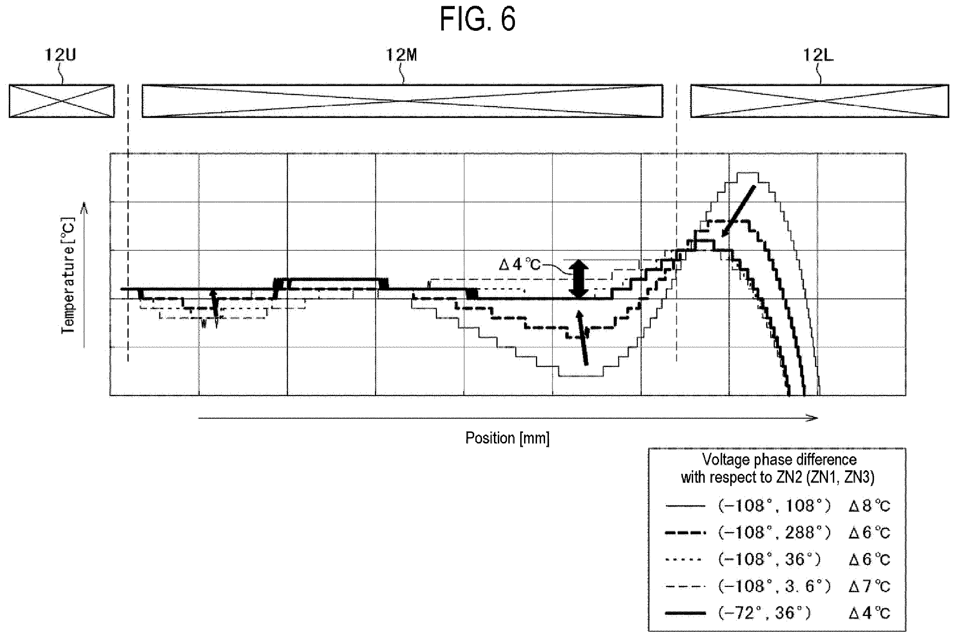

FIG. 6 is a diagram showing an improvement of temperature ripple by a phase difference according to the embodiments of the present disclosure. FIG. 6 shows five examples of the phase differences PD1 and PD2 of the drive voltages of the first zone ZN1 and the third zone ZN3 with respect to the phase of the drive voltage of the second zone ZN2.

The first example is (-108°, 108°), the second example is (-108°, 288°), the third example is (-108°, 36°), the fourth example is (-108°, 3.6°), and the fifth example is (-72°, 36°). As the example changes from the first example to the fifth example, a temperature drop between the first zone ZN1 and the second zone ZN2 is improved, and a temperature drop between the second zone ZN2 and the third zone ZN3 is also improved, thereby improving heat generation efficiency. Further, an amount of heat generated in the third zone ZN3 is reduced. In this way, the deviations (spatial fluctuations) of the temperatures in the vicinity of the zone boundaries from the target values may be directly controlled to be reduced or eliminated by the voltage phase difference. Further, the heat uniformity may be improved.

### (Substrate Processing Flow)

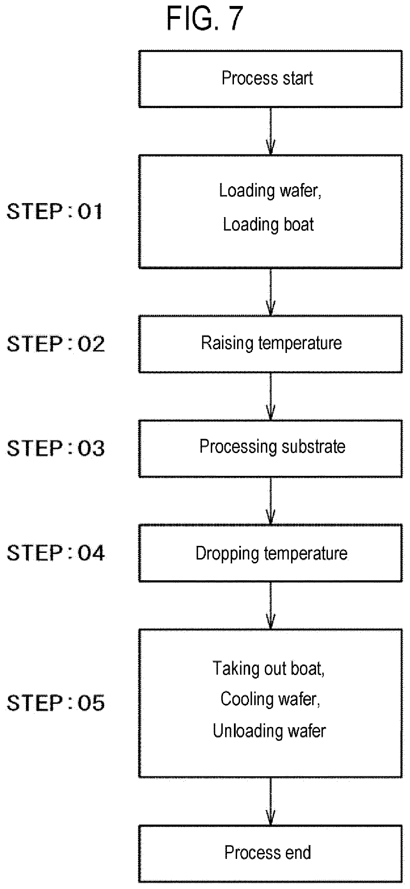

Next, a method of processing a substrate (also called a method of manufacturing a semiconductor device) using the above-described substrate processing apparatus 1 is described with reference to the flow diagram of FIG. 7. In this process, as one step in the method of manufacturing the semiconductor device, a SiC wafer 4 is annealed in the reaction chamber 8 in an argon (Ar) atmosphere. In the present disclosure, the processing temperature means the temperature of the wafer 4 or the temperature of the reaction chamber 8, and the processing pressure means the internal pressure of the reaction chamber 8. Also, in the following description, the operation of various parts constituting the substrate processing apparatus 1 is controlled by the controller 210.

### (STEP: 01)

First, a plurality of wafers 4 are loaded (i.e., charged) into the boat 3 that is lowered outside the reaction chamber 8.

Next, the boat 3 is raised and loaded into the reaction chamber 8 to load (prepare) the wafers 4. Further, the lower opening of the reaction tube 7 is closed (i.e., sealed) by the seal cap 31. Then, after the reaction chamber 8 is once vacuum-exhausted by the vacuum pump 29, an Ar gas is supplied into the reaction chamber 8 from the gas supply unit 21 and the internal pressure of the reaction chamber 8 is regulated to a predetermined pressure by the APC valve 28. At this time, a N₂ gas is supplied into the temperature measurement assembly 34, which is a thermocouple, through a purge gas introduction pipe.

### (STEP: 02)

Then, based on the temperature information detected by the thermocouple of the temperature measurement assembly 34, the AC power applied to the induction coil 12 is regulated so that the wafers 4 reach a predetermined processing temperature, thereby performing a temperature rising process to raise the temperature to a predetermined temperature with a predetermined temperature rising rate.

### (STEP: 03)

Next, the wafers 4 are exposed to an Ar atmosphere at a predetermined temperature and pressure for a predetermined time. This activates ion-implanted impurities or removes oxygen from surfaces of the wafers 4, producing annealed wafers.

Processing conditions for activation annealing the wafers 4 are exemplified as follows:
Processing temperature (wafer temperature): 1,500 degrees C to 1,900 degrees C
Processing pressure (process chamber internal pressure): 1 Pa to normal pressure
Ar gas: 1 sccm to 5 SLM
N₂ gas: 1 sccm to 5 SLM.

By setting each of the processing conditions to a value within the respective range, a film forming process may proceed appropriately. Note that the notation of a numerical range such as "1,500 degrees C to 1,900 degrees C" mentioned above means that the lower limit and the upper limit are included in the range. For example, "1,500 degrees C to 1,900 degrees C" means "1,500 degrees C or higher and 1,900 degrees C or lower." The same applies to other numerical ranges.

### (STEP: 04)

Next, the AC power applied to the induction coil 12 is regulated, and a temperature dropping process is performed to drop the temperature to a predetermined temperature with a predetermined temperature dropping rate.

### (STEP: 05)

Next, the APC valve 28 is closed to return the internal pressure of the reaction chamber 8 to the atmospheric pressure. After that, the seal cap 31 is lowered, and the boat 3 is taken out (i.e., unloaded) from the reaction tube 7. After the boat 3 is taken out, the wafers 4 are further cooled until they reach a temperature at which they become transferrable. Finally, the processed wafers 4 are stored from the boat 3 into a cassette by a transferer (not shown).

The controller 210 may also give different phase differences to the first coil 12U, the second coil 12M, and the third coil 12L during the temperature rising (STEP: 02), at a constant temperature during substrate processing after temperature rising (STEP: 03), and during the temperature dropping (STEP: 04) by using the semifixed phase shift amounts 121U, 121M, and 121L.

### (Control Flow in Temperature Rising Process)

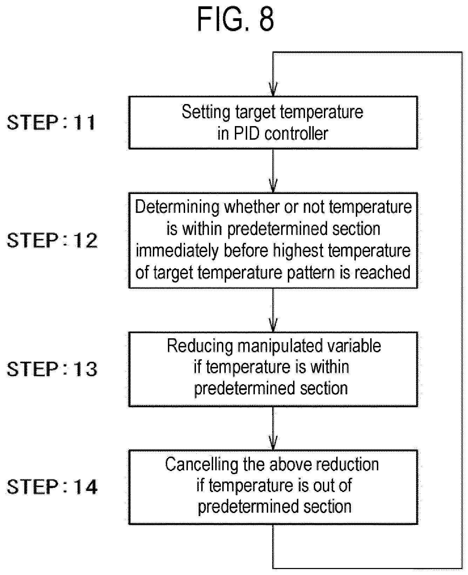

Next, a control flow in the temperature rising process is described with reference to FIG. 8. FIG. 8 is a control flow diagram in the temperature rising process according to the embodiments of the present disclosure.

### (STEP: 11)

The controller 210 sets a current target temperature in the temperature regulator 225, which is a PID controller, according to a predetermined target temperature pattern (temperature rising rate).

### (STEP: 12)

The temperature regulator 225 determines whether or not the temperature is within a predetermined section immediately before a highest temperature of the target temperature pattern is reached (for example, whether or not the current temperature is between the highest temperature - 10 degrees C and the highest temperature).

### (STEP: 13)

If the temperature is within the predetermined section, the temperature regulator 225 reduces the power setting values 122U, 122M, and 122L, which are the manipulated variables, by multiplying them by a hard limit or a predetermined coefficient less than 1. In other words, the temperature regulator 225 reduces the corresponding manipulated variables (the power setting values 122U, 122M, and 122L) for each of the plurality of heating zones (ZN1, ZN2, and ZN3) in the predetermined section immediately before the temperature value reaches the target value. Further, the temperature regulator 225 reduces the manipulated variables so as not to exceed upper limits of the manipulated variables (the power setting values 122U, 122M, and 122L) determined according to the target values.

### (STEP: 14)

The temperature regulator 225 cancels the above-mentioned reduction if the temperature is out of the predetermined section. A flow of repeating the above-described STEP: 11 to STEP: 14 is performed. By performing the above operations (STEP:11 to STEP: 14), it is possible to suppress temperature overshoot (temporal fluctuation) when transitioning from the temperature rising to the constant temperature.

The hard limit (inner limit type) is an operation that rounds off a PID calculation result by a power limit value and is determined according to the target temperature. For example, in the case the power limit value is 80%, when the PID calculation result is 95%, the values of the power setting values 122U, 122M, and 122L are regulated so that heater output using the induction coil 12 becomes 80%.

In the above description of STEP: 11 to STEP: 14, as shown in FIG. 2, the controller 210 and the temperature regulator 225 are provided separately, but the temperature regulator 225 may also be provided as a part of the controller 210. In this case, STEP:11-STEP:14 are executed by the controller 210.

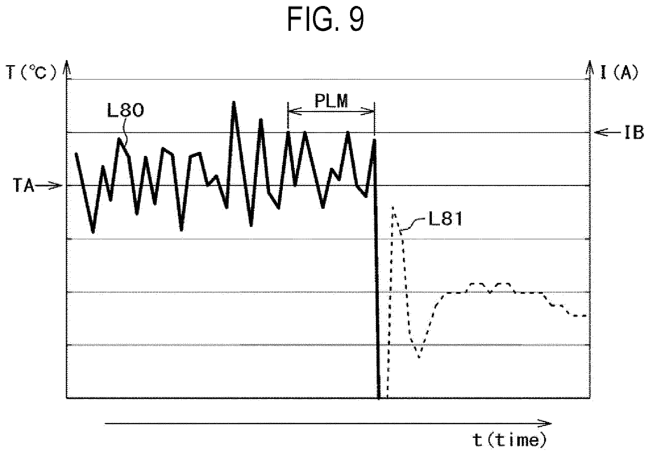

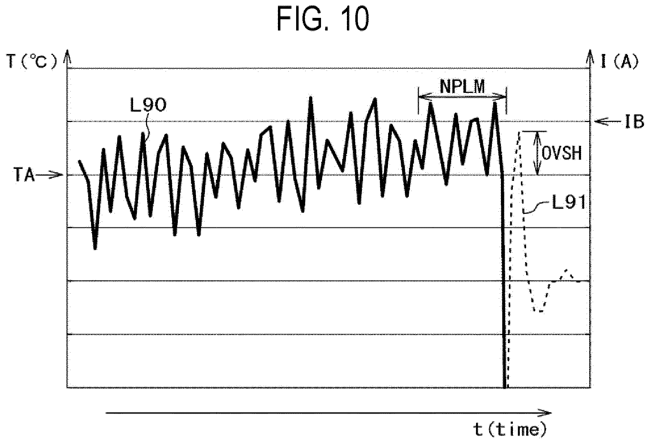

Next, results of temperature control are described with reference to FIGS. 9 and 10. FIG. 9 is a diagram showing a temperature control result when there is power reduction according to the embodiments of the present disclosure. FIG. 10 is a diagram showing a temperature control result when there is no power reduction according to a comparative example. In FIG. 9 and FIG. 10, the first vertical axis on the left represents a temperature T (degrees C) detected by the thermocouple of the temperature measurement assembly 34, and an arrow TA indicates the target value of the temperature. The horizontal axis represents time t. The second vertical axis on the right represents, for example, a current I (A) supplied to the first coil 12U of the induction coil 12, and an arrow IB indicates the power limit value. The target temperature value TA may be, for example, 1,750 degrees C. The target temperature value may be selected from, for example, 1,700 degrees C to 1,800 degrees C.

In FIGS. 9 and 10, solid lines L80 and L90 indicate changes in the current supplied to the first coil 12U. Dotted lines L81 and L91 indicate deviations of the temperature detected by the thermocouple of the temperature measurement assembly 34 from the target temperature value TA.

As shown in FIG. 9, in the solid line L80, the current supplied to the first coil 12U is power-limited at the power limit value indicated by the arrow IB during a period PLM. Therefore, the temperature detected by the thermocouple indicated by the dotted line L81 is controlled so as not to exceed the target temperature value TA. In other words, it is configured such that no overshoot occurs when the temperature transitions from the temperature rising to the constant temperature. Herein, the period PLM is the predetermined section immediately before the highest temperature of the target temperature pattern is reached.

On the other hand, in FIG. 10, the current supplied to the first coil 12U is not power-limited at the power limit value indicated by the arrow IB during a period NPLM, as indicated by the solid line L90. Therefore, the temperature detected by the thermocouple indicated by the dotted line L91 exceeds the target temperature value TA. In other words, an overshoot OVSH occurs in the temperature.

Note that, although the configuration for preventing the occurrence of an overshoot is described above, it may also be used for a configuration for preventing the occurrence of an undershoot.

By using the configuration (FIG. 9) of the present disclosure, it is possible to fully satisfy, for example, a specification in which the overshoot is 2 degrees C or lower (overshoot OVSH < 2 degrees C) with respect to the target temperature value TA.

### (Modification of Power Supply)

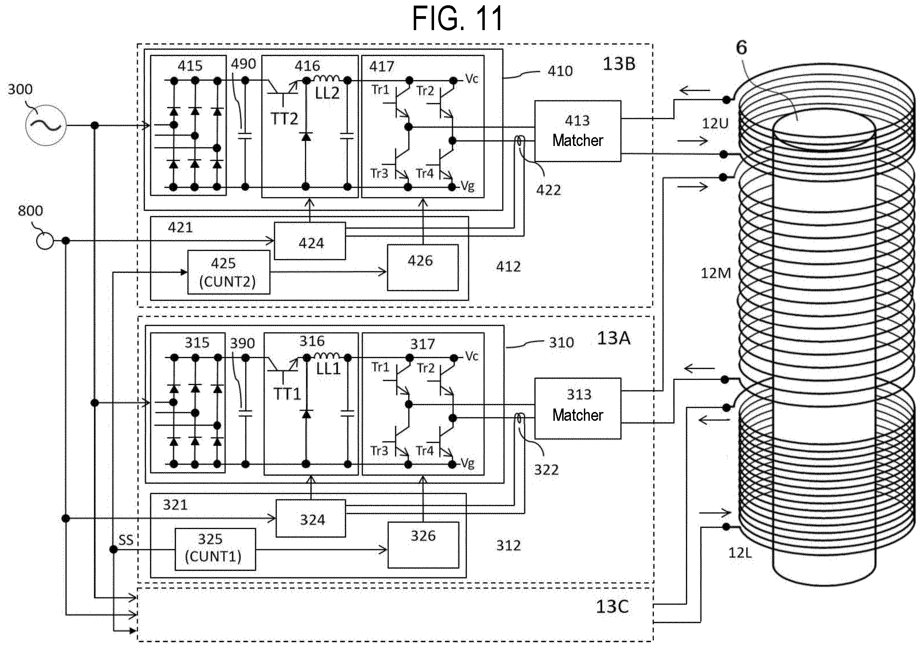

A modification of the present disclosure is described mainly with reference to FIGS. 11 to 15.

FIG. 11 is a block diagram of a power supply according to a modification of the present disclosure. The power supply includes a first power supply (hereinafter referred to as a first AC power source) 13A, a second power supply (hereinafter referred to as a second AC power source) 13B, and a third power supply (hereinafter referred to as a third AC power source) 13C as radio-frequency power sources corresponding to the coil 12M, the coil 12U, and the coil 12L, respectively. These AC power sources may be collectively referred to as an induction heating apparatus. In the following description, the coil 12M is described as a first coil, the coil 12U as a second coil, and the coil 12L as a third coil. In FIG. 11, a circuit configuration of the first AC power source 13A and a circuit configuration of the second AC power source 13B are shown as representative examples. A circuit configuration of the third AC power source 13C is the same as the circuit configuration of the second AC power source 13B, and is therefore not shown.

In the following, transistors (TT1 and Tr1 toTr4) are described as bipolar transistors, and it is assumed that on and off states of the bipolar transistors are controlled based on a drive signal (base drive signal) supplied to a base electrode, which is a control terminal. The transistors (TT1 and Tr1 to Tr4) may also be MOSFETs (Metal-Oxide-Semiconductor Field-Effect Transistors) or IGBTs (Insulated-Gate Bipolar Transistors). In this case, the control terminal is a gate electrode, and on and off states of the MOSFETs or IGBTs are controlled based on a drive signal (gate drive signal or gate signal) supplied to the gate electrode.

The first AC power source 13A includes a first inverter power source 310, a first oscillation controller 312, and a first matcher (also called a matching part) 313. The first inverter power source 310 includes a first rectifier circuit 315, a first step-down chopper circuit (first chopper circuit) 316, and a first inverter circuit 317. The first inverter circuit 317 corresponds to the bridge circuit 103 in FIG. 3.

The first oscillation controller 312 includes a first oscillation control circuit 321 and a first sensor 322. The first oscillation control circuit 321 includes a first chopper drive unit 324, a synchronization signal generating unit 325, and a first inverter drive unit (first drive unit) 326. The first inverter drive unit 326 corresponds to the PWM circuit 102 in FIG. 3.

The first rectifier circuit 315 rectifies three-phase commercial power from an AC power source 300 to provide DC power. The first rectifier circuit 315 is configured with a three-phase bridge diode rectifier as shown in FIG. 11. The three-phase bridge diode rectifier is well known, and therefore, description of its operation is omitted. A first smoothing capacitor 390 is provided in a subsequent stage of the first rectifier circuit 315 and bears radio-frequency components of a load current.

The first step-down chopper circuit 316, which may be rephrased as a step-down regulator converter, receives the DC power output by the first rectifier circuit 315 and steps down the input voltage to generate an output voltage. At this time, the first step-down chopper circuit 316 changes the DC voltage output by the first rectifier circuit 315 to a predetermined voltage that is free of pulsation caused by a commercial power frequency. The first step-down chopper circuit 316 includes a transistor TT1, a diode element, a coil LL1, and a capacitance element. When the transistor TT1 is in the on state, it stores energy in the coil LL1, and when the transistor TT1 is in the off state, it releases the energy stored in the coil LL1. The longer an on time of the transistor TT1, the higher its output voltage, and the shorter the on time of the transistor TT1, the lower its output voltage.

The first inverter circuit 317 operates to inversely convert the DC power, which is the output of the first step-down chopper circuit 316, into radio-frequency power to be provided to the first coil 12M.

The first matcher 313, which is a two-terminal pair circuit interposed between the first inverter circuit 317 and the first coil 12M, brings load impedance of the first inverter circuit 317 close to a suitable value and provides DC insulation between the first inverter circuit 317 and the first coil 12M. The first matcher 313 may use a circuit in which an input current and an output current are in phase, and may, for example, include a transformer, a parallel capacitor provided to cancel self-inductances of primary and secondary windings of the transformer, and a series capacitor provided directly on either the primary or secondary winding of the transformer.

The first sensor 322 detects current or power output by the first inverter circuit 317.

The first chopper drive unit 324 outputs an output signal to a base of the transistor TT1 of the first step-down chopper circuit 316 and feedback-controls the output voltage of the first step-down chopper circuit 316 so that a controlled variable based on the current, etc. detected by the first sensor 322 becomes a target value specified in an output current setting 800. The controlled variable is, for example, an effective value of the current. The first chopper drive unit 324, which may be referred to as a first feedback controller, is configured to be capable of changing an output voltage of the first inverter circuit 317 by controlling the first step-down chopper circuit 316.

The first oscillation control circuit 321 oscillates a radio-frequency signal of a predetermined frequency to generate a first clock signal of 100 MHz. For example, it includes a temperature-compensated crystal oscillator with a frequency of 100 MHz, and the oscillated radio-frequency signal may be used as the first clock signal as is.

The synchronization signal generating unit 325 also includes a frequency divider that divides the first clock signal from the oscillator by a predetermined division ratio to generate a first radio-frequency signal that is a drive frequency of the first coil 12M. The first radio-frequency signal may be, for example, a radio-frequency signal of a frequency of 10 kHz that is generated by dividing the first clock signal by 1/10,000.

The synchronization signal generating unit 325 is configured to be capable of generating a synchronization signal SS given with a predetermined phase difference with respect to the first radio-frequency signal, and output the synchronization signal SS to a synchronization signal receiving unit 425. In other words, the synchronization signal generating unit 325 generates synchronization signals SS1 and SS2 that serve as a reference for an oscillation timing of each of the second AC power source 13B and the third AC power source 13C, and outputs the synchronization signals SS1 and SS2 to the synchronization signal receiving units 425 of the second AC power source 13B and the third AC power source 13C, respectively.

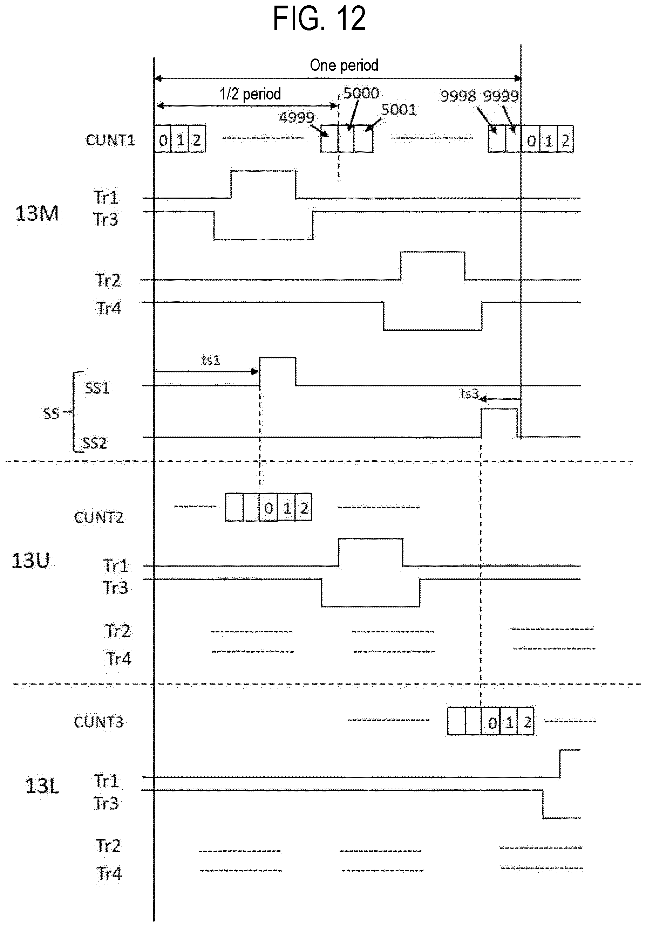

The synchronization signal generating unit 325 or the first inverter drive unit 326 includes a first counter (CUNT1) that counts the first clock signal. The synchronization signal generating unit 325 generates the synchronization signal SS (synchronization signals SS1 and SS2 with phases shifted by arbitrary set times ts1 and ts3: *see* FIG. 12) based on a count value of the first counter. The first counter is, for example, a programmable counter, and is cleared to 0 when the next clock is detected with a count value of 9,999. The frequency divider of the synchronization signal generating unit 325 may be constituted by the first counter.

The first inverter drive unit 326 is configured to generate a drive signal for the first inverter circuit 317 based on the first radio-frequency signal generated by the synchronization signal generating unit 325. That is, the first inverter drive unit 326 may be configured to generate and output four output signals (drive signals) for the transistors Tr1 to Tr4 of the first inverter circuit 317 based on the count value of the first counter (*see* FIG. 12). The drive signals are base drive signals and gate drive signals. Also, the first radio-frequency signal may be any type of signal as long as it includes frequency and phase information and is capable of generating the drive signal for the first inverter circuit 317, and may be, for example, one or more specific count values held by the first counter.

The second AC power source 13B includes a second inverter power source 410, a second oscillation controller 412, and a second matcher (also called a matching part) 413. The second inverter power source 410 includes a second rectifier circuit 415, a second step-down chopper circuit (second chopper circuit) 416, and a second inverter circuit 417. The second rectifier circuit 415, the second step-down chopper circuit 416, and the second inverter circuit 417 may be formed with the same configurations and functions as the first rectifier circuit 315, the first step-down chopper circuit 316, and the first inverter circuit 317, and therefore, explanation thereof may be omitted.

The second oscillation controller 412 includes a second oscillation control circuit 421 and a second sensor 422. The second oscillation control circuit 421 includes a second chopper drive unit 424, a first synchronization signal receiving unit 425, and a second inverter drive unit (second drive unit) 426. The second inverter drive unit 426 corresponds to the PWM circuit 102 in FIG. 3. The second sensor 422, the second chopper drive unit 424, and the second inverter drive unit 426 are formed with the same configurations and functions as the first sensor 322, the first chopper drive unit 324, and the first inverter drive unit 326, and therefore, explanation thereof may be omitted.

The second rectifier circuit 415 rectifies three-phase AC power from the AC power source 300 to provide DC power.

A smoothing capacitor 490 is provided in a subsequent stage of the second rectifier circuit 415.

The second step-down chopper circuit 416 changes a voltage of the DC power output by the second rectifier circuit 415.

The second inverter circuit 417 operates to inversely convert the DC power, which is the output of the second step-down chopper circuit 416, into radio-frequency power to be provided to the second coil 12U.

The second matcher 413 is interposed between the second inverter circuit 417 and the second coil 12U.

The second sensor 422 detects current or power output by the second inverter circuit 417.

The second chopper drive unit 424 outputs an output signal to a base of a transistor TT2 of the second step-down chopper circuit 416 and feedback-controls the output voltage of the second step-down chopper circuit 416 so that a controlled variable based on the current, etc. detected by the second sensor 422 approaches the target value specified in the output current setting 800.

The first synchronization signal receiving unit 425 receives the synchronization signal SS1 from the synchronization signal generating unit 325 and generates a second radio-frequency signal with the same frequency as the first radio-frequency signal generated by the synchronization signal generating unit 325 and given with a predetermined phase difference. The second radio-frequency signal may be the same as the synchronization signal SS1.

The second oscillation controller 412 or the synchronization signal receiving unit 425 includes a temperature-compensated crystal oscillator similar to that of the first oscillation controller 312 or receives the first clock signal from the first oscillation controller 312, thereby obtaining a second clock signal that is synchronized with or possesses substantially the same frequency as the first clock signal. The second clock signal may be generated from a signal with a lower frequency than the first clock signal, such as the synchronization signal SS1 received from the synchronization signal generating unit 325, by using, for example, a phase-locked loop (PLL) circuit.

The second inverter drive unit 426 or the first synchronization signal receiving unit 425 includes a second counter (CUNT2) that counts the second clock signal and is reset by the synchronization signal SS. The second inverter drive unit 426 is configured to generate and output four output signals (drive signals) for the transistors Tr1 to Tr4 of the second inverter circuit 417 based on the count value of the second counter (*see* FIG. 12).

The third AC power source 13C includes a third inverter power source, a third oscillation controller, and a third matcher 513 (also referred to as a matching part). The third inverter power source includes a third rectifier circuit, a third step-down chopper circuit, and a third inverter circuit. The third rectifier circuit, the third step-down chopper circuit, and the third inverter circuit are formed with the same configurations and functions as the second rectifier circuit 415, the second step-down chopper circuit 416, and the second inverter circuit 417, and therefore, explanation thereof is omitted. The third AC power source 13C includes substantially the same configuration as the second AC power source 13B and supplies radio-frequency power to the third coil 12L. The third matcher is interposed between the third AC power source 13C and the third coil 12L.

The third oscillation controller includes a third oscillation control circuit and a third sensor. The third oscillation control circuit includes a third chopper drive unit, a second synchronization signal receiving unit, and a third inverter drive unit. The third sensor, the third chopper drive unit, the third inverter drive unit, and the second synchronization signal receiving unit are formed with the same configurations and functions as the second sensor 422, the second chopper drive unit 424, the second inverter drive unit 426, and the first synchronization signal receiving unit 425, and therefore, explanation thereof is omitted. In this manner, in this modification, the three power supplies are operated at the same fixed frequency. In other words, each power supply does not perform tuning control to change the frequency according to the individual load impedance. This makes the operation of the induction heating apparatus 13 stable and easy to handle.

Next, synchronization of the first inverter circuit 317, the second inverter circuit 417, and the third inverter circuit 517 is described with reference to FIG. 12.

FIG. 12 diagrammatically depicts the count value of the first counter of the first AC power source 13A, the drive signals of the four transistors Tr1 to Tr4 of the first inverter circuit 317, the synchronization signal SS, the count value of the second counter of the second AC power source 13B, the drive signals of the four transistors Tr1 to Tr4 of the second inverter circuit 417, a count value of the third counter (CUNT3) of the third AC power source 13C, and drive signals of the four transistors Tr1 to Tr4 of the third inverter circuit 517.

The first counter counts the first clock signal, which is the reference clock, and returns to 0 after counting for one period. The count value starts from, for example, 0 and returns to 0 after 9,999. The count value for 1/2 period is, for example, 4,999. For example, when the frequency of the reference clock is 100 MHz, the period of the reference clock is 10ns, and counting 10,000 times results in a frequency of 10 kHz, that is, a cycle with a period of 100 µs.

The synchronization signal SS output from the synchronization signal generating unit 325 of the first AC power source 13A is received by the first and second synchronization signal receiving units 425 of the second AC power source 13B and the third AC power source 13C, and at that timing, the count values of the second counter and the third counter are reset to 0. The synchronization signal SS includes the synchronization signal SS1 output to the first synchronization signal receiving unit 425 of the second AC power source 13B, and the synchronization signal SS2 output to the second synchronization signal receiving unit of the third AC power source 13C.

The synchronization signal generating unit 325 generates the synchronization signals SS1 and SS3 with phases shifted by arbitrary set times ts1 and ts3 within a range of -180 to 180 degrees, based on the count value of the first counter. For example, the set time ts1 is set as a delay time (i.e. lagging phase) from the count value of 0, and the set time ts3 is set as a time until the count value becomes 0 (i.e. leading phase).

The four drive signals of the four transistors Tr1 to Tr4 of the first inverter circuit 317 are configured to be generated based on the count value of 0 of the first counter, as shown in FIG. 12. Similarly, the four drive signals of the four transistors Tr1 to Tr4 of the second inverter circuit 417 are generated based on the count value of 0 of the second counter, and the four drive signals of the four transistors Tr1 to Tr4 of the third inverter circuit are generated based on the count value of 0 of the third counter.

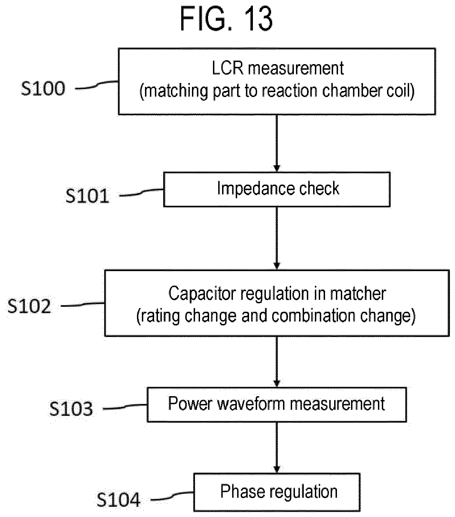

Next, a method of setting a reference phase of the first AC power source 13A, the second AC power source 13B, and the third AC power source 13C is described with reference to FIG. 13. FIG. 13 is a flow diagram for explaining a method of setting the reference phase of the power supply according to the modification of the present disclosure.

### (S100: LCR Measurement)

By using an LCR meter, impedances (load impedance) seen from the first AC power source 13A, the second AC power source 13B, and the third AC power source 13C to the respective matchers 313, 413, and 513 are measured in sequence. At this time, an output of a power supply that is not being measured is short-circuited. By using equivalent series resistance obtained here, effective power contributing to induction heating may be calculated from the output current of each power supply.

### (S101: Impedance Check)

It is checked whether or not the impedance at 10 kHz measured in S100 is within a specified range. If the impedance is within the specified range, the method proceeds to S103. If the impedance is not within the specified range, the connections of the matchers 313, 413, and 513 and the respective coils 12M, 12U, and 12L are checked, and the method returns to S100 to measure the impedance again.

### (S102: Capacitor Regulation in Matcher)

If the impedance is not within the specified range in S101, ratings of capacitors configured by series and parallel connections inside the matchers 313, 413, and 513 of the first AC power source 13A, the second AC power source 13B, and the third AC power source 13C are changed, and the combinations thereof are reconstructed to bring the ratings to be within the specified range of S101.

### (S103: Power Waveform Measurement)

The first AC power source 13A, the second AC power source 13B, and the third AC power source 13C are actually operated to cause oscillation and check oscillation waveforms.

### (S104: Phase Regulation)

A phase difference is regulated by comparing measured waveforms. When current phases during the oscillation of the first AC power source 13A, the second AC power source 13B, and the third AC power source 13C are aligned, that is, when magnetic fields created by each of the coils are combined in phase, a decrease in magnetic flux density at the coil boundaries is most suppressed, and this state is used as a reference.

When the first AC power source 13A, the second AC power source 13B, and the third AC power source 13C cause simultaneous oscillation, the current in each of the coils is a combined current of a current from its own circuit power source and an induced current from the other circuit power sources. Therefore, even if current waveforms during the simultaneous oscillation are observed, it is extremely difficult to determine whether or not the current phases are aligned.

Therefore, data of the output voltage and current when the first AC power source 13A, the second AC power source 13B, and the third AC power source 13C cause the oscillation individually are obtained, and it is determined how much voltage phase correction is needed to align the current phases. The voltage phase is defined with a state when the second AC power source 13B and the third AC power source 13C are in opposite phase to the first AC power source 13A as a reference (i.e., a phase difference of 0 µs).

In other words, the power sources of non-excited coils (for example, the non-excited coils are the second coil 12U and the third coil 12L) are shorted, and a voltage-current phase difference of the power source output of an excited coil (for example, the excited coil is the first coil 12M) is measured, and a voltage phase difference that makes the currents in phase is determined as the reference phase. The combination of the non-excited coils and the excited coil is changed so that the excited coil becomes the first coil 12M, the second coil 12U, or the third coil 12L. When the first AC power source 13A, the second AC power source 13B, and the third AC power source 13C cause the simultaneous oscillation by using the reference phase obtained in this manner, the cases where the coils are excited one by one are superposed, and the current phases of the first AC power source 13A, the second AC power source 13B, and the third AC power source 13C are aligned.

When correcting the deviation from the target temperature value near the zone boundaries, the voltage phase difference is further regulated with this reference phase as a starting point. With this method, as long as the load impedance does not fluctuate greatly, it is possible to maintain the current phase difference at a predetermined value simply by maintaining the voltage phase difference at a predetermined value, and this method is superior to a method of directly controlling the current phase in that the former does not need complex PID (Proportional-Integral-Differential) control based on a current phase.

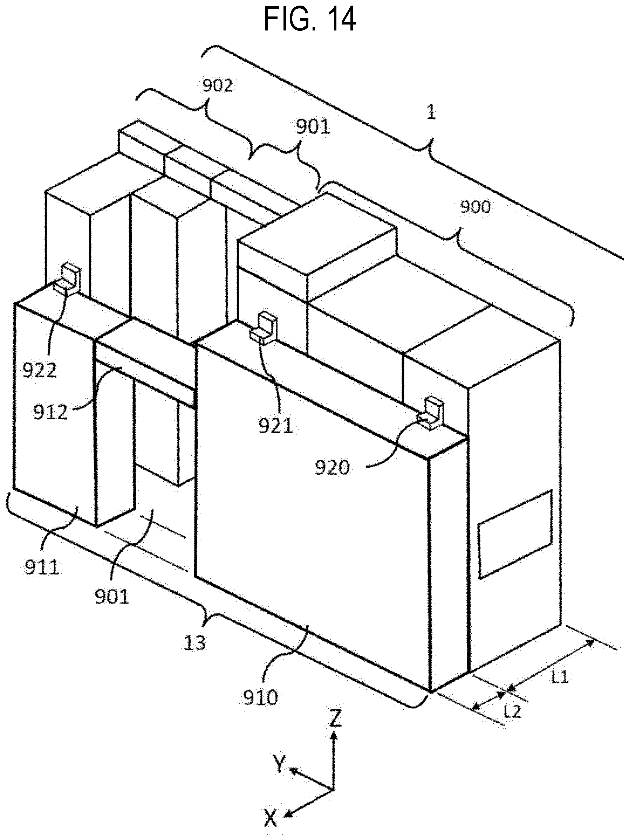

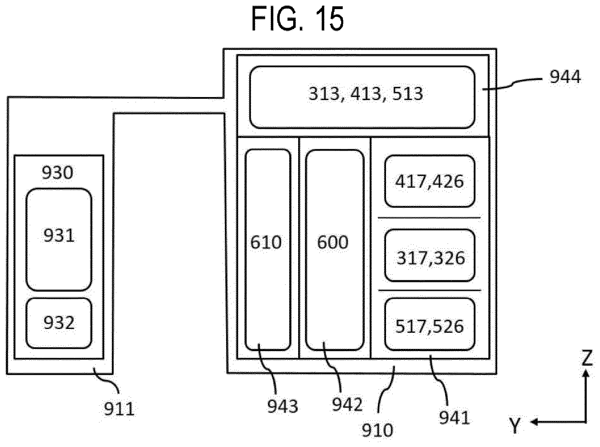

Next, a perspective view of the induction heating apparatus 13 juxtaposed to the substrate processing apparatus 1 is described with reference to FIG. 14. FIG. 14 is a perspective view of the induction heating apparatus juxtaposed to the substrate processing apparatus according to the modification of the present disclosure. FIG. 15 is a diagram for explaining a rack of the induction heating apparatus according to the modification of the present disclosure.

As shown in FIG. 14, the substrate processing apparatus 1 includes, in a front-rear direction Y, a main body 900 and a utility box 902 provided behind the main body 900 with a maintenance area 901 sandwiched therebetween. The utility box 902 is provided with, for example, a gas box, a power source box, a controller box, and a valve box. A width L1 of the substrate processing apparatus 1 in a width direction X is, for example, about 850 to 1,000 mm.

The induction heating apparatus 13 is provided to be juxtaposed to the substrate processing apparatus 1. The induction heating apparatus 13 includes, in the front-rear direction Y, a first rack 910, a second rack 911 disposed behind the first rack 910 with the maintenance area 901 interposed therebetween, and a connecting portion 912 provided above the maintenance area 901 in a height direction Z. The connecting portion 912 is provided between the first rack 910 and the second rack 911 and includes pipes, wiring, and the like installed therein. A width L2 of the induction heating apparatus 13 in the width direction X is, for example, about 425 mm.

A height of the induction heating apparatus 13 in the height direction Z is configured to be lower than a height of the substrate processing apparatus 1. Therefore, in order to prevent the induction heating apparatus 13 from tipping over, the induction heating apparatus 13 is fixed to the substrate processing apparatus 1 by L-shaped fixing brackets 920, 921, and 922 which serve as connecting brackets. The fixing brackets 920 and 921 are provided between a side of the main body 900 and an upper surface of the first rack 910. The fixing bracket 922 is provided between an upper surface of the second rack 911 and a side of the utility box 902. In this example, three fixing brackets 920, 921, and 922 are provided, but a single fixing bracket 920 may suffice as long as it prevents the induction heating apparatus 13 from tipping over. In this way, the first rack 910 is formed with a width that is less than half a width of the substrate processing apparatus 1 including the first coil 12M, the second coil 12U, and the third coil 12L, and is configured so that it is juxtaposable to the substrate processing apparatus 1 by being connected using the fixing brackets 920 and 921 to prevent the first rack 910 from tipping over.

In this way, the induction heating apparatus 13 is elongated in the height direction Z within a range that does not exceed the length of the substrate processing apparatus, and is configured by being divided into the first rack 910 and the second rack 911 in the front-to-rear direction Y to correspond to the main body 900 and the utility box 902. This makes it possible to prevent an increase in footprint when juxtaposed to the substrate processing apparatus 1.

As shown in FIG. 15, the first rack 910 includes a first region 941, a second region 942, a third region 943, and a fourth region 944. The first region 941, the second region 942, and the third region 943 are disposed in this order from front to rear in the front-to-rear direction Y. The fourth region 944 is disposed above the first region 941, the second region 942, and the third region 943 in the height direction Z.

In the first region 941, the first inverter circuit 317 and the first inverter drive unit 326 of the first AC power source 13A, the second inverter circuit 417 and the second inverter drive unit 426 of the second AC power source 13B, and the third inverter circuit 517 and the third inverter drive unit 526 of the third power supply are vertically arranged in this order in the height direction Z, with their respective longitudinal directions aligned in the front-to-rear direction. The first chopper drive unit 324, the second chopper drive unit 424, and the third chopper drive unit may be arranged in the vertical direction in the first region 941. The first oscillation controller 312, the second oscillation controller 412 and the third oscillation controller may likewise be arranged in the vertical direction in the first region 941.

A converter 600 that rectifies AC power and supplies the rectified AC power as DC power to the first AC power source 13A, the second AC power source 13B, and the third AC power source 13C is disposed behind the first inverter circuit 317 and the first inverter drive unit 326, the second inverter circuit 417 and the second inverter drive unit 426 of the second AC power source 13B, and the third inverter circuit 517 and the third inverter drive unit 526 of the third power supply, which are arranged in the first region 941, that is, in the second region 942. The converter 600 includes or replaces the first rectifier circuit 315, the first smoothing capacitor 390, the second rectifier circuit 415, the second smoothing capacitor 490, the third rectifier circuit, and a third smoothing capacitor.

A power receiving board 610 is disposed behind the converter 600 disposed in the second region 942, that is, in the third region 943. The power receiving board 610 includes a no-fuse breaker, a terminal board, etc. to supply AC power 300.

In the fourth region 944 disposed above the first region 941, the second region 942, and the third region 943, that is, above the first inverter circuit 317 and the first inverter drive unit 326, the second inverter circuit 417 and the second inverter drive unit 426 of the second AC power source 13B, the third inverter circuit 517 and the third inverter drive unit 526 of the third power supply, and the converter 600, the first matcher 313, the second matcher 413, and the third matcher 513 are arranged in the front-to-rear direction in the longitudinal direction Y.

The second rack 911 includes a cooling water system 930 arranged thereon, which includes a valve panel 931 and piping 932 of the cooling water system. The cooling water system 930 is provided to supply cooling water for cooling the first AC power source 13A, the second AC power source 13B, and the third AC power source 13C.

The present disclosure is not limited to the above-described embodiments and further includes various modifications. For example, the above-described embodiments are described in detail to clearly explain the present disclosure and is not limited to one including the entire described configurations.

Furthermore, the above-described configurations, functions, and controllers serving as control parts are described with a focus on examples of creating programs that realize some or an entirety of them, but it goes without saying that some or the entirety of them may be realized in hardware, for example by designing some or the entirety of them in an integrated circuit. That is, an entirety of or some of the functions of a processor may be realized by integrated circuits such as ASICs (Application Specific Integrated Circuits) and FPGAs (Field Programmable Gate Arrays) instead of programs.

An example of a batch-type substrate processing apparatus that processes a plurality of substrates at a time is described in the above-described embodiments. The present disclosure is not limited to the above-described embodiments, but may also be suitably applied, for example, to a single-wafer type substrate processing apparatus that processes a single substrate or several substrates at a time. In addition, an example in which a film is formed using a substrate processing apparatus provided with a cold-wall-type process furnace is described in the above-described embodiments. The present disclosure is not limited to the above-described embodiments, but may also be suitably applied to a case where a film is formed using a substrate processing apparatus provided with a hot-wall-type process furnace.

According to the present disclosure in some embodiments, it is possible to reduce temperature discrepancies at zone boundaries of induction heating.

While certain embodiments are described, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A substrate processing apparatus (1) comprising:
(a) a process tube (7) in which a substrate (4) is accommodated and heat-treated;
(b) a plurality of coils (12U, 12M, 12L) that are disposed along a longitudinal direction of the process tube (7) and supplied with radio-frequency power from a power source (13U, 13M, 13L); and
(c) a controller (210) configured to be capable of setting a phase difference between two adjacent coils, among the plurality of coils (12U, 12M, 12L), to a predetermined value,
wherein (c1) the predetermined value is changeable and is set so as to make a temperature discrepancy occurring in a vicinity of a boundary between the two adjacent coils smaller than a temperature discrepancy when the phase difference is set to zero.

2. The substrate processing apparatus (1) of Claim 1, wherein the power source (13U, 13M, 13L) is configured to be capable of maintaining the phase difference at the set predetermined value while controlling the power supplied to the plurality of coils (12U, 12M, 12L) to a specified value.

3. The substrate processing apparatus (1) of Claim 1 or 2, wherein the controller (210) is configured to be capable of setting the predetermined value to different values during temperature rising and at a constant temperature after the temperature rising.

4. The substrate processing apparatus (1) of Claim 2, wherein the power source (13U, 13M, 13L) is configured to be capable of exciting two adjacent coils, among the plurality of coils (12U, 12M, 12L), with waveforms of an arbitrary phase difference within a predetermined range around a phase difference of 180 degrees, which is an opposite phase, and the power source (13U, 13M, 13L) is optionally configured to be capable of electrically changing the predetermined value by changing a phase difference between voltages output in response to each of the plurality of coils (12U, 12M, 12L).

5. The substrate processing apparatus (1) of any one of Claims 1 to 4, wherein the phase difference is a voltage phase difference,
wherein the substrate processing apparatus (1) further optionally comprises: a heating element that is provided to be closer to the substrate (4) than the plurality of coils (12U, 12M, 12L) and is inductively heated by the plurality of coils (12U, 12M, 12L), and
wherein the heating element is disposed over a longer range than any of the plurality of coils (12U, 12M, 12L) along the longitudinal direction of the process tube (7).

6. The substrate processing apparatus (1) of any one of Claims 1 to 5, further comprising:
a protective tube (32) that is disposed inside the process tube (7), communicates with an outside of the process tube (7), and provides a space that allows a temperature sensor (15) to move in the longitudinal direction of the process tube (7); and
a port (42) that is provided at a lid covering an opening of the process tube (7) and substantially air-tightly connects the lid and the protective tube (32),
wherein the plurality of coils (12U, 12M, 12L) are optionally wound around the process tube (7) for each of a plurality of zones that divide the process tube (7) in the longitudinal direction, and
wherein a spacing between two adjacent coils of the plurality of coils (12U, 12M, 12L) is optionally wider than a pitch of each of the two adjacent coils.

7. The substrate processing apparatus (1) of any one of Claims 1 to 6, wherein the plurality of coils (12U, 12M, 12L) include a first coil (12U), a second coil (12M), and a third coil (12L) that are arranged in order in the longitudinal direction of the process tube (7),
wherein the second coil (12M) is longer than the first coil (12U) and the third coil (12L), and a pitch of the second coil is wider than a pitch of the first coil (12U) and a pitch of the third coil (12L), and
wherein a region of the process tube (7) to be uniformly heated is set to extend beyond both ends of the second coil (12M).

8. The substrate processing apparatus (1) of any one of Claims 1 to 7, further comprising:
(e) a plurality of temperature sensors (15) that obtain a plurality of temperature values corresponding to a plurality of heating zones; and
(f) a temperature regulator configured to be capable of outputting a plurality of manipulated variables representing power to be supplied to the plurality of coils (12U, 12M, 12L) so that the plurality of temperature values approach corresponding target values,
wherein (f1) for each of the plurality of heating zones, the temperature regulator reduces a corresponding manipulated variable, among the plurality of manipulated variables, in a predetermined section immediately before a corresponding temperature value, among the plurality of temperature values, reaches a corresponding target value among the target values, and
wherein the manipulated variable is preferably reduced such that the manipulated value does not exceed an upper limit of the manipulated variable determined according to the corresponding target value, and is preferably reduced by multiplying the manipulated variable by a predetermined coefficient, less than 1.

9. A method of processing a substrate (4), comprising:
in a substrate processing apparatus (1) including a process tube (7) in which the substrate (4) is accommodated and heat-treated, a plurality of coils (12U, 12M, 12L) that are disposed along a longitudinal direction of the process tube (7) and supplied with radio-frequency power from a power source (13U, 13M, 13L), and a controller (210) configured to be capable of setting a phase difference between two adjacent coils, among the plurality of coils (12U, 12M, 12L), to a predetermined value,
(a) raising a temperature of the substrate (4) accommodated in the process tube (7) by supplying the radio-frequency power to the plurality of coils (12U, 12M, 12L) disposed along the longitudinal direction of the process tube (7); and
(b) heat-treating the substrate (4) at a controlled temperature,
wherein (c) in at least one selected from the group of the act of raising the temperature of the substrate (4) and the act of heat-treating the substrate (4), the phase difference between the two adjacent coils, among the plurality of coils (12U, 12M, 12L), is set so as to make a temperature discrepancy occurring in a vicinity of a boundary between the two adjacent coils smaller than a temperature discrepancy when the phase difference is set to zero.

10. An induction heating apparatus (13) comprising:
a first power supply (13A) including:
(a1) a first inverter circuit (317) that inversely converts DC power to radio-frequency power to be provided to a first coil (12M); and
(b1) a first oscillation controller (312) including a synchronization signal generating unit (325) that oscillates a radio-frequency signal of a predetermined frequency and generates a synchronization signal, and a first drive unit (326) that generates a drive signal for the first inverter circuit (317) based on a first radio-frequency signal generated by the synchronization signal generating unit (325); and
a second power supply (13B) including:
(a2) a second inverter circuit (417) that inversely converts DC power to radio-frequency power to be provided to a second coil (12U); and
(b2) a second oscillation controller (412) including a synchronization signal receiving unit (425) that receives the synchronization signal from the first oscillation controller (312) and generates a second radio-frequency signal with a predetermined phase difference at a same frequency as the first radio-frequency signal, and a second drive unit (426) that generates a drive signal for the second inverter circuit (417) based on the second radio-frequency signal.

11. The induction heating apparatus (13) of Claim 10, wherein the first power supply (13A) includes:
(c1) a first sensor (322) that detects current or power output by the first inverter circuit (317), as a controlled variable; and
(d1) a first feedback controller that is configured to be capable of changing an output voltage of the first inverter circuit (317) and to control the output voltage so that the controlled variable detected by the first sensor (322) approaches a specified target value,
wherein the second power supply (13B) includes:
(c2) a second sensor (422) that detects current or power output by the second inverter circuit (417), as a controlled variable; and
(d2) a second feedback controller that is configured to be capable of changing an output voltage of the second inverter circuit (417) and to control the output voltage so that the controlled variable detected by the second sensor (422) approaches a specified target value,
wherein the first power supply (13A) optionally includes:
(c1) a first rectifier circuit (315) that rectifies AC power to provide DC power;
(d1) a first chopper circuit (316) that changes a voltage of the DC power output by the first rectifier circuit (315);
(e1) a sensor that detects the current or the power output by the first inverter circuit (317), as a controlled variable; and
(f1) a first chopper drive unit (324) that feedback-controls an output voltage of the first chopper circuit (316) so that the detected controlled variable approaches a specified target value, and
wherein the second power supply (13B) optionally includes:
(c2) a second rectifier circuit (415) that rectifies AC power to provide DC power;
(d2) a second chopper circuit (416) that changes a voltage of the DC power output by the second rectifier circuit (415);
(e2) a sensor that detects the current or the power output by the second inverter circuit (417), as a controlled variable; and
(f2) a second chopper drive unit (424) that feedback-controls an output voltage of the second chopper circuit (416) so that the detected controlled variable approaches a specified target value.

12. The induction heating apparatus (13) of Claim 10 or 11, wherein the synchronization signal generating unit (325) is configured to be capable of generating the synchronization signal with the predetermined phase difference with respect to the first radio-frequency signal, and outputting the synchronization signal to the synchronization signal receiving unit (425),
wherein the synchronization signal receiving unit (425) oscillates the second radio-frequency signal based on a timing of the synchronization signal,
wherein the frequency of the first radio-frequency signal is fixedly operated,
wherein the synchronization signal generating unit (325) optionally includes a first counter that counts a first clock signal with a higher frequency than the first radio-frequency signal,
wherein the first drive unit (326) optionally generates the drive signal for the first inverter circuit (317) including four gate signals based on a count value of the first counter,
wherein the synchronization signal receiving unit (425) optionally includes a second counter that counts a second clock signal with a substantially same frequency as the first clock signal and is reset by the synchronization signal, and
wherein the second drive unit (426) optionally generates the drive signal for the second inverter circuit (417) including four gate signals based on a count value of the second counter.

13. The induction heating apparatus (13) of any one of Claims 10 to 12, further comprising:
a first matcher (313) inserted between the first inverter circuit (317) and the first coil (12M);
a second matcher (413) inserted between the second inverter circuit (417) and the second coil (12U);
a third power supply (13C) including a substantially same configuration as the second power supply (13B) and supplying radio-frequency power to a third coil (12L); and
a third matcher (513) inserted between the third power supply (13C) and the third coil (12L),
wherein the first power supply to the third power supply (13A, 13B, 13C) are optionally arranged in a vertical direction such that a longitudinal direction of each of the first power supply to the third power supply (13A, 13B, 13C) is in a front-to-rear direction,
wherein a converter (600) that rectifies AC power and supplies rectified AC power as the DC power to the first power supply to the third power supply (13A, 13B, 13C) is optionally disposed behind the first power supply to the third power supply (13A, 13B, 13C) arranged, and
wherein the first matcher to the third matcher (313, 413, 513) are optionally arranged in the front-to-rear direction above the first power supply to the third power supply (13A, 13B, 13C) and the converter (600), and
optionally comprising: a first rack (910) for disposing a power receiving board (610) behind the converter (600).

14. The induction heating apparatus (13) of Claim 13, wherein a second rack (911) for disposing a cooling water system is disposed behind the first rack (910) with a maintenance area interposed between the first rack (910) and the second rack (911), and/or
wherein the first rack (910) is formed with a width equal to or less than half a width of a substrate processing apparatus (1) including the first coil (12M) to the third coil (12L) and is configured to be connected to be juxtaposed to the substrate processing apparatus (1) so as not to tip over.

15. An induction heating method, comprising:
oscillating, by a first oscillation controller (312) of a first power supply (13A), a radio-frequency signal of a predetermined frequency to generate a first radio-frequency signal and a synchronization signal;
generating, by the first oscillation controller (312), a drive signal for a first inverter circuit (317) based on the first radio-frequency signal;
inversely converting, by the first inverter circuit (317) of the first power supply (13A), DC power to radio-frequency power to be provided to a first coil (12M);
receiving, by a second oscillation controller (412) of a second power supply (13B), the synchronization signal from the first oscillation controller (312), and generating a second radio-frequency signal with a predetermined phase difference at a same frequency as the first radio-frequency signal;
generating, by the second oscillation controller (412), a drive signal for a second inverter circuit (417) based on the second radio-frequency signal; and
inversely converting, by the second inverter circuit (417) of the second power supply (13B), DC power to radio-frequency power to be provided to a second coil (12U).
